(19) Europäisches Patentamt / European Patent Office / Office européen des brevets

(11) **EP 3 067 952 B1**

(12) **EUROPEAN PATENT SPECIFICATION**

(45) Date of publication and mention
of the grant of the patent:
**15.03.2023 Bulletin 2023/11**

(21) Application number: **15168463.6**

(22) Date of filing: **20.05.2015**

(51) International Patent Classification (IPC):
***H01L 51/52*** *(2006.01)*

(52) Cooperative Patent Classification (CPC):
**H10K 71/80; H10K 50/858; H10K 77/111;**
Y02E 10/549

(54) **OLED AND PROCESS FOR HIGH EFFICIENCY OLED DEVICES**

OLED UND VERFAHREN FÜR HOCHEFFIZIENTE OLED-VORRICHTUNGEN

OLED ET PROCÉDÉ DE DISPOSITIFS OLED À HAUTE EFFICACITÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.03.2015 US 201514641095**

(43) Date of publication of application:
**14.09.2016 Bulletin 2016/37**

(73) Proprietor: **Universal Display Corporation
Ewing, NJ 08618 (US)**

(72) Inventors:
• **Ma, Ruiqing
Ewing, NJ 08618 (US)**
• **Zhou, Zhaoqun
Ewing, NJ 08618 (US)**
• **McGraw, Gregory
Ewing, NJ 08618 (US)**
• **Lin, Chun
Ewing, NJ 08618 (US)**

(74) Representative: **Pistolesi, Roberto
Dragotti & Associati Srl
Via Nino Bixio, 7
20129 Milano (IT)**

(56) References cited:
EP-A1- 2 966 669      WO-A1-2008/139370
WO-A2-2004/051738     GB-A- 2 482 193
US-A1- 2012 228 601   US-A1- 2012 305 950

**Description**

CROSS-REFERENCE TO RELATED APPLICATIONS

This is a continuation-in-part of U.S. Patent Application Serial No. 14/042,194, filed September 30, 2013, entitled "Methods to Fabricate Flexible OLED Lighting Devices", and U.S. Patent Application Serial No. 14/106,274, filed December 13, 2013, entitled "OLED on Curved Substrate".

JOINT RESEARCH

The claimed invention was made by, on behalf of, and/or in connection with one or more of the following parties to a joint university corporation research agreement: Regents of the University of Michigan, Princeton University, The University of Southern California, and the Universal Display Corporation. The agreement was in effect on or before the effective filing date of the claimed invention, and the claimed invention was made as a result of activities undertaken within the scope of the agreement.

FIELD OF THE INVENTION

The present invention relates generally to the fabrication of high efficiency OLED devices and more specifically, to the fabrication of OLED substrates with topographical features or curvatures on both sides of the substrate according to the claims.

BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may also have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Patent Nos. 5,844,363, 6,303,238, and 5,707,745.

In the industry today OLED lighting panels are generally made on flat surfaces such as glass or planarized flexible substrates such as plastics and metal foils. Building flexible OLED lighting devices on flexible substrates provide both benefits and challenges. It is easier to obtain a high refractive index from transparent plastic materials than from conventional glass substrates. This enables a better outcoupling efficiency for OLEDs on plastic. However, a flexible plastic film is very difficult to handle. Keeping it flat during fabrication process can be a challenge. Another challenge with plastic substrates is that they tend to have rough surfaces and random spikes on the surface. These defects can easily cause shorting in the OLED devices grown on them. Further, OLED lighting devices constructed on flat surfaces may not exhibit the best light extraction.

Documents WO2008139370 (A), US2012305950 (A), GB2482193 (A), and EP2966669 (A) disclose OLEDs comprising light extraction units.

BRIEF SUMMARY

According to embodiments of the disclosed subject matter, a system and method is provided to substantially address the problems associated with the prior art and provide for the fabrication of high efficiency OLED devices and more specifically, the fabrication of OLED substrates with topographical features or curvatures on both sides, and OLED devices formed thereon and conforming to the topographical features or curvatures of the substrate according to the claims.

Some embodiments of the disclosed subject matter provide a system and method for fabricating an organic light emitting device (OLED) according to the claims on a substrate including steps of providing a mold having surface features, forming a substrate over the mold, fabricating an OLED over the substrate while the substrate is in the mold, and removing the mold from the substrate having the OLED fabricated thereon.

Some embodiments of the disclosed subject matter provide a system and method for fabricating an organic light emitting device (OLED) according to the claims on a substrate including steps of forming a substrate over the mold, wherein the resulting substrate includes topographical features or curvatures on both sides of the substrate.

Some embodiments of the disclosed subject matter further provide a system and method for fabricating the substrate according to the claims using a volume-reducing material on a mold with topographical features, where areas of greatest deposited material undergo the greatest volume reduction to thereby create specific areas of curvature on the top surface of the resulting substrate, and contact with the mold create specific areas of curvature on the bottom surface of the resulting substrate.

In some embodiments of the disclosed subject matter, the substrate top surface curvature can be filled with a planarization material possessing a refractive index greater than or equal to a refractive index of the substrate prior to fabricating an OLED over the substrate.

In some embodiments of the disclosed subject matter, the substrate top surface curvature can be filled with a conformal coating or material possessing a refractive index greater than or equal to a refractive index of the substrate and which maintains some of the topography of the substrate top surface prior to fabricating an OLED over the substrate.

In some embodiments of the disclosed subject matter, the substrate top surface curvature can be metallized prior to fabricating an OLED over the substrate such that the substrate top surface forms respective convex mirrors.

In some embodiments of the disclosed subject matter, the substrate is formed according to the claims by applying a volume-reducing substrate material coating over the mold, and subsequently curing the coating to reduce the volume of the substrate and thereby create specific areas of curvature on the top surface of the resulting substrate prior to fabricating the OLED.

In some embodiments of the disclosed subject matter, a refractive index of the substrate is greater than 1.6. In some embodiments, the refractive index of the substrate is greater than 1.7.

Accordingly, a system and method according to the claims is provided for applying a volume-reducing substrate material onto a mold with topographical features that generates a smooth but non-flat surface on both sides of the substrate which can enhance light extraction of OLEDs that are built on top of the substrate. The resulting substrate includes surface features on a first substrate surface complementary to the surface features of the mold, such as spherical lens features, and includes surface features on a second substrate surface, such as dimple features, complementary to the curvature of the spherical lens features on the first substrate surface and resulting from processing of the volume-reducing substrate material.

The system and method is further provided for applying a planarization material over the second substrate surface, wherein the planarization material has a refractive index greater than or equal to a refractive index of the substrate, and wherein the features on the second substrate surface can result in the planarization material having formed thereon, features complementary to the features on the second substrate surface. Some embodiments of the present invention further provide a method of applying a metallized surface on the second substrate surface to form convex mirror features on the second substrate surface.

BRIEF DESCRIPTION OF THE DRAWINGS

The accompanying drawings, which are incorporated herein and form a part of the specification, illustrate embodiments of the present invention and, together with the description, further serve to explain the principles of the invention and to enable a person skilled in the pertinent art to make and use the invention.

FIG. 1 shows an illustrative organic light emitting device according to some embodiments of the invention.

FIG. 2 shows an illustrative inverted organic light emitting device that does not have a separate electron transport layer according to some embodiments of the invention.

FIG. 3 is a flow chart of an illustrative process for fabricating an OLED on a mold according to some embodiments of the invention.

FIG. 4 is a flow chart of an illustrative process for fabricating an OLED according to some embodiments of the invention.

FIG. 5 is a flow chart of another illustrative process for fabricating an OLED on a mold according to some embodiments of the invention.

FIGS. 6A-6G are illustrative views of transient structures formed during the coating approach OLED fabrication process shown in FIG. 5 according to some embodiments of the invention.

FIGS. 7A and 7B are sectional views illustrating the fabrication of substrates using a mold with micro-well features and resulting in a substrate with topographical features or curvatures on both sides of the substrate according to some embodiments of the invention.

FIG. 8 is a sectional view illustrating the fabrication of substrates using a mold with semi-spherical features and resulting in a substrate with topographical features or curvatures on both sides of the substrate according to some embodiments of the invention.

FIG. 9 is a sectional view illustrating the fabrication of substrates using a mold with sine function shape features and resulting in a substrate with topographical features or curvatures on both sides of the substrate according to some embodiments of the invention.

FIG. 10 is a sectional view illustrating the fabrication of substrates using another mold with micro-well features and resulting in a substrate with topographical features or curvatures on both sides of the substrate according to some embodiments of the invention.

FIGS. 11A to 11C are sectional views of a mold and removal process according to some embodiments of the invention.

FIG. 12A is a sectional view illustrating a substrate surface curvature or dimple that can be filled with a planarization material possessing a refractive index greater than or equal to a refractive index of the substrate according to some embodiments of the invention.

FIG. 12B is a sectional view illustrating a substrate surface curvature or dimple that can be filled with a conformal coating or material possessing a refractive index greater than or equal to a refractive index of the substrate and which maintains some of the topography of the dimpled substrate surface according to some embodiments of the invention.

FIG. 12C is a sectional view illustrating a substrate surface curvature or dimple that is metallized such that the reflective surface deposited on each dimple forms a respective convex mirror when viewed from the opposite side of the substrate according to some embodiments of the invention.

FIG. 13 is an illustration of a simple unit cell of the simulated substrate with symmetry conditions at boundaries according to some embodiments of the invention.

FIG. 14 is a plot illustrating efficiency of the convex mirror outcouplers as a function of h/r according to some embodiments of the invention.

FIG. 15 is a plot illustrating efficiency of the convex mirror array as a function of the mirror's radius of curvature for a given aspect ratio r/R according to some embodiments of the invention.

FIG 16A is a scanning electron microscope (SEM) image of the topographical features or curvatures on the bottom surface of a substrate at low magnification according to some embodiments of the invention.

FIG. 16B is a SEM image of the topographical features or curvatures on the bottom surface of the substrate of FIG. 16A at high magnification according to some embodiments of the invention.

FIG. 17A is a SEM image of the topographical features or curvatures on the top surface of the substrate of FIG. 16A at low magnification according to some embodiments of the invention.

FIG. 17B is a SEM image of the topographical features or curvatures on the top surface of the substrate of FIG. 16A at high magnification according to some embodiments of the invention.

FIG. 18 is an illustrative view of a conveyor belt manufacturing apparatus used in some embodiments of fabricating an OLED.

DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Patent No. 4,769,292. Fluorescent emission generally occurs in a time frame of less than 10 nanoseconds.

More recently, OLEDs having emissive materials that emit light from triplet states ("phosphorescence") have been demonstrated. Examples include Baldo et al., "Highly Efficient Phosphorescent Emission from Organic Electroluminescent Devices," Nature, Vol. 395, 151-154, 1998; ("Baldo-I") and Baldo et al., "Very high-efficiency green organic light-emitting devices based on electro phosphorescence," Appl. Phys. Lett., vol. 75, No. 3, 4-6 (1999) ("Baldo-II"). Phosphorescence is described in more detail in U.S. Patent No. 7,279,704 at cols. 5-6.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as farther away from the vacuum level in the downward direction. Thus, the definitions of HOMO and LUMO energy levels follow a different convention than work functions.

More details on OLEDs, and the definitions described above, can be found in U.S. Patent No. 7,279704.

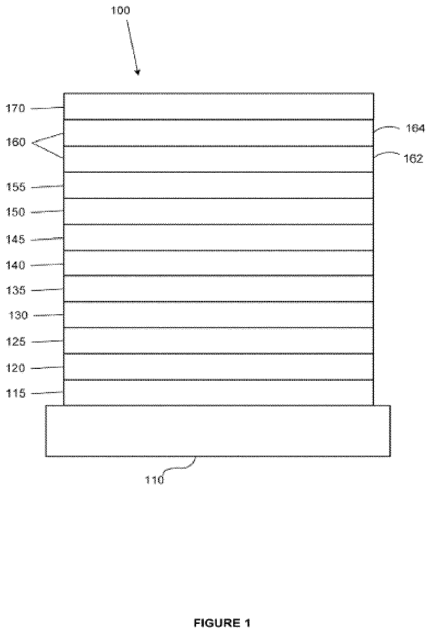

FIG. 1 shows an illustrative organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in U.S. Patent No. 7,279,704 at cols. 6-10.

More examples for each of these layers are available. For example, a flexible and transparent substrate-anode combination is disclosed in U.S. Patent No. 5,844,363. An example of a p-doped hole transport layer is m-MTDATA doped with $F_4$-TCNQ at a molar ratio of 50:1, as disclosed in U.S. Patent Application Publication No. 2003/0230980. Examples of emissive and host materials are disclosed in U.S. Patent No. 6,303,238 to Thompson et al.. An example of an n-doped electron transport layer is BPhen doped with Li at a molar ratio of 1:1, as disclosed in U.S. Patent Application Publication No. 2003/0230980. U.S. Patent Nos. 5,703,436 and 5,707,745, disclose examples of cathodes including compound cathodes having a thin layer of metal such as Mg:Ag with an overlying transparent, electrically-conductive, sputter-deposited ITO layer. The theory and use of blocking layers is described in more detail in U.S. Patent No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

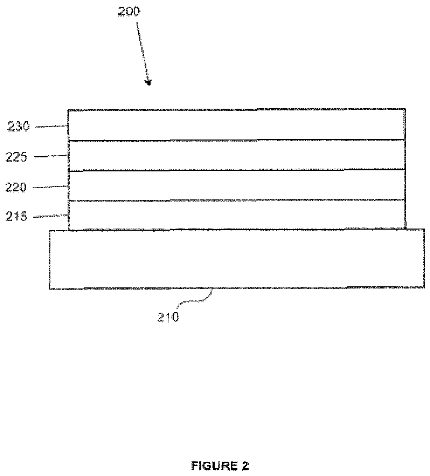

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting examples, and it is understood that embodiments of the invention may be used in connection with a wide variety of other structures. The specific materials and structures described are illustrative in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Patent No. 5,247,190 to Friend et al. By way of further example, OLEDs having a single organic layer may be used. OLEDs may be stacked for example, as described in U.S. Patent No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Patent No. 6,091,195 to Forrest et al., and/or a pit structure as described in U.S. Patent No. 5,834,893 to Bulovic et al.

Unless otherwise specified, any of the layers of the various embodiments may be deposited by any suitable method. For the organic layers, preferred methods include thermal evaporation, ink-jet, such as described in U.S. Patent Nos. 6,013,982 and 6,087,196; organic vapor phase deposition (OVPD), such as described in U.S. Patent No. 6,337,102 to Forrest et al; and deposition by organic vapor jet printing (OVJP), such as described in U.S. Patent No. 7,431,968. Other suitable deposition methods include spin coating and other solution based processes.

Solution based processes are preferably carried out in nitrogen or other inert atmosphere. For the other layers, preferred methods include thermal evaporation. Preferred patterning methods include deposition through a mask, cold welding such as described in U.S. Patent Nos. 6,294,398 and 6,468,819, and patterning associated with some of the deposition methods such as ink-jet and OVJD. Other methods may also be used.

The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under, or next to a substrate, an electrode, or over any other parts of a device including an edge. The barrier layer may include single layer, or multiple layers. The barrier layer may be formed by various known chemical vapor deposition techniques and may include compositions having a single phase as well as compositions having multiple phases.

Any suitable material or combination of materials may be used for the barrier layer. The barrier layer may incorporate an inorganic or an organic compound or both. The preferred barrier layer comprises a mixture of a polymeric material and a non-polymeric material as described in U.S. Patent No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Building flexible OLED lighting devices on flexible substrates provide both benefits and challenges. It is easier to obtain a high refractive index from transparent plastic materials than from conventional glass substrates. This enables a better outcoupling efficiency for OLEDs on plastic. However, a flexible plastic film is very difficult to handle. Keeping it flat during fabrication process can be a challenge. Another challenge with plastic substrates is that they tend to have rough surfaces and random spikes on the surface. These defects can easily cause shorting in the OLED devices grown on them. However, the methods described herein overcome both these challenges.

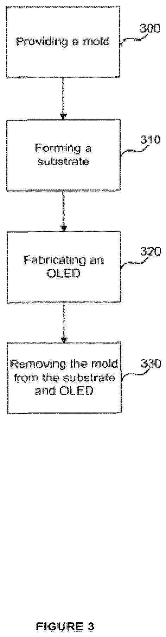

FIG. 3 is a high level flowchart of an illustrative method for fabricating an OLED on a substrate including a step 300 of providing a mold, a step 310 of forming a substrate, a step 320 of fabricating an OLED, and a step 330 of removing the mold from the substrate and OLED. The process shown in FIG. 3 is merely illustrative and can include additional steps or fewer steps.

Step 300 includes providing a mold. The mold can have at least two functions: i) to act as a support during the following process steps; and ii) to generate the desired surface features on the flexible substrate to be formed on the mold in the next step. Thus, the mold can be designed to provide the desired surface features. The surface features are preferably designed to efficiently extract light from the OLED device.

The surface features on the mold, and the composition of the substrate material, are designed to produce features on the top and/or bottom surfaces of the substrate that will be formed in the next step. The bottom substrate surface features are made as a result of direct mold surface contact, and can be spherical lenses, aspherical lenses that enhance light extraction. The top substrate surface features are made as a result of the creation of the bottom substrate surface features and the volume-reducing composition of the substrate material, and can be dimple features, complementary to the curvature of the features on the bottom substrate surface. This is especially beneficial to OLED lighting devices. In some embodiments, the lens features can be radially symmetric about an axis normal to the flat surface of the mold. A spherical lens can be a hemispherical shape with $H/R=1$ where H and R are the peak-to-trough height and radius (in the plane) of the lens. Aspheric lens shape can be defined by a polynomial such as quadratic, cubic, parabolic. The aspheric lens can be shaped such that lens height H over radius R, $H/R> 1$, $H/R>2$.

In some embodiments, the peak to trough height H of the surface features should be at least comparable to the thickness of the OLED device (100 nm). In other embodiments, H should be at least comparable to or greater than the wavelength of the light in the substrate (wavelength in vacuum divided by refractive index of the substrate material) generated in the OLED device deposited thereafter. For example, when the index of the substrate is 2.0, H should be at least comparable to 200 nm or greater. Thus in some embodiments H, can be 400 nm or greater. These minimum dimensions are preferred because, at smaller dimensions, the optics and outcoupling may be less desirable. It can also be preferred to have larger minimum dimensions to help the fabrication of the surface features on the mold. In such embodiments, the preferred H can be at least 1 $\mu$m, at least 5 $\mu$m, at least 10 $\mu$m, at least 50 $\mu$m, or at least 100 $\mu$m. These minimum values for H are preferred because, as the minimum becomes larger, it becomes easier to fabricate the mold features. But, minimums different from those disclosed in this paragraph may be used depending on whether it is acceptable to trade-off optical considerations and ease of manufacturing for other considerations.

In some embodiments, the peak to trough height H of the surface features should be at most 300 $\mu$m, and preferably at most 100 $\mu$m. At larger values for H, undesirable effects may occur. For example, bubbles may form if a single thick coat is used. While these effects may be mitigated by using multiple coating steps, or through material and process parameter selection, such mitigation involves its own trade-offs. Also, if overall thickness becomes too large, flexibility may decrease, which may be undesirable for some uses.

In some embodiments, the surface features can cover an area or form an area array. Preferably, a center-to-center lateral distance between adjacent surface features is not more than ten times the value of H.

The surface features can be arranged regularly or randomly. The size can be uniform or different. It is preferred that the surface features are packed close together with a fill factor of at least 80%, at least 90%, or at least 95%. Here fill factor is defined as the ratio of the surface area occupied by surface features (projection of the surface features on the base surface) over the base surface area.

In some embodiments, the mold can be rigid. This means that the mold is rigid enough to be able to withstand, without significant flexing or distortion, the normal handling associated with semiconductor or standard glass based flat panel display fabrication - i.e., the mold can easily be picked up and moved around without breaking or significantly bending. This allows the process to overcome the challenge of keeping the substrate formed on the mold flat during fabrication of the OLED. The rigidity of the mold can be determined by calculating its flexural rigidity D. This is defined as the force couple required to bend a rigid structure to a unit curvature. For a thin plate of uniform elastic material, flexural rigidity can be described mathematically in Equation (1) as:

$$D = Et^3 / 12(1 - \mu^2) \qquad (1)$$

Where D is flexural rigidity (in Nm), E is Young's modulus (in $Nm^{-2}$), $\mu$ is Poisson's ratio and t is the thickness of the material (in m). This equation is described in J. A. Rogers, G. R. Bogart, and J. Mater. Res., 16 (1), 217, 2001. The more flexible the plate, the lower the flexural rigidity. The flexural rigidity of any substrate can be theoretically calculated if Young's modulus, Poisson's ratio and the thickness of the substrate are known.

It may be difficult to calculate flexural rigidity for thin films from material properties or from data provided in a textbook. This is especially true for composite films or multilayer films. However, once a measurement is made for a particular structure, flexural rigidity can be readily altered in a reasonably predictable way by one of skill in the art by adjusting parameters such as thickness. Here we focus on the cantilever method for determining flexural rigidity. The apparatus required is a fixed angle flexometer. A rectangular strip of material is supported on a horizontal platform in a direction perpendicular to the edge of the platform. The strip is extended in the direction of its length so that an increasing part overhangs and bends down under its own weight. When the tip of the strip of material has reached a plane passing through the edge of the platform and inclined at an angle of $\theta = 41.5°$ below the horizontal, the overhanging length L is equal to twice the bending length C of the specimen (C = 0.5L at $\theta = 41.5°$).

Bending length (in m) is denoted by C, where C is the cube root of the ratio of flexural rigidity to the weight per unit area of the material ($D = WC^3$), where W is weight per unit area (in $Nm^{-2}$), which for a uniform strip is given by $W = \rho tg$, described mathematically in Equation (2) as:

$$D = WC^3 = \rho tgC^3 \quad (2)$$

Where $\rho$ is density (in $Kgm^{-3}$), g is gravitation acceleration (9.81 $ms^{-2}$) and t is the thickness of the substrate (in m).

Here we use both Equations (1) and (2) to determine the best mold substrate material/thickness combination to be used for making flexible electronics devices. Some examples are shown in Table 1 below. E, $\mu$, and $\rho$ are material properties and are determined once the material is selected.

**Table 1**

|  | E(G Pa) | $\mu$ | t(mm) | D | $\rho$ (Kg/m3) | g (m/s2) | C(m) |
|---|---|---|---|---|---|---|---|
| Borosilicate Glass | 65 | 0.2 | 0.7 | 2.015969 | 2230 | 9.81 | 0.50871 |
| Borosilicate Glass | 65 | 0.2 | 0.5 | 0.734682 | 2230 | 9.81 | 0.406492 |
| stainless steel | 200 | 0.3 | 0.5 | 2.515799 | 8020 | 9.81 | 0.399903 |
| stainless steel | 200 | 0.3 | 0.33 | 0.723282 | 8020 | 9.81 | 0.303145 |
| stainless steel | 200 | 0.3 | 0.1 | 0.020126 | 8020 | 9.81 | 0.136765 |

It is common practice in the flat panel display industry to use 0.7 mm or 0.5 mm glass for display fabrication. This means a flexural rigidity of >0.7 Nm is good enough for the process. Accordingly, in some embodiments, the mold has a flexural rigidity of at least 0.7 Nm. When glass is used as the mold, the same thickness of glass can be applied.

When a different mold material is used, the thickness of the material can be calculated to make sure a similar level of flexural rigidity is achieved. As can be seen in Table 1 above, stainless steel foil with a thickness of 0.33 mm has similar flexural rigidity as 0.5 mm borosilicate glass sheet. Another way to decide on the thickness of mold material is to use similar bending length. Stainless steel and glass at similar thickness give similar bending length.

In some embodiments, the mold has a flexural rigidity greater than the flexural rigidity of an assembly of the substrate and an OLED, including when the OLED includes a hard coat.

In some embodiments, the mold can include a base layer and a patterned layer having the surface features. In some embodiments, the base layer has a flexural rigidity greater than the flexural rigidity of the patterned layer.

The material for the mold can depend upon the type of material used to form the substrate and the release process. The mold can be fabricated from a material with mechanical and optical properties suitable for the process. The type of mold used can depend upon the types of surface features required and the methods available to make the surface features. If a laser is used for release the substrate, then a transparent mold material such as glass is needed.

In some embodiments, the mold can be made directly using processes such as machining or 3D printing.

In other embodiments, the mold can be formed from a master with the same shape as the desired features. A master can be made using a wide variety of materials, including semiconductor wafers and photoresists traditionally used in microfabrication. Where a master is used, the mold itself can be made by any of a variety of methods that transfer features from the master to the mold. For example, a liquid can be applied over the master, cured to solidify, and removed. Other methods, including those described herein for forming the substrate from the mold, can be used.

The features required for a mold can be machined directly onto commercially available aluminum, hardened steel, or stainless steel pieces using micromachining techniques. These can include conventional CNC machining, laser cutting, and microelectrical discharge machining ($\mu$-EDM). Metal molds can also be electroformed from a master immersed in a plating bath. These molds tend to be made from elemental metals such as Ni. Metal molds can also be used to emboss features into plastic sheets that have been softened by exposure to heat or solvent. When Si or glass are used to make a mold, surface features can be defined by standard semiconductor processing techniques.

Returning to FIG. 3, step 310 can include forming a substrate over the mold. As used herein, the term "over" means as measured in a direction moving away from the mold in the direction of the side of the mold with surface features, i.e., further away from the mold. The term over is intended to allow for one or more intermediate layers between the mold and the substrate. For example, where a first layer is described as "disposed over" or "formed over" a second layer, the first layer is disposed further away from mold. There may be other layers between the first and second layer, unless it is specified that the first layer is "in contact with" the second layer. For example, a cathode can be described as "disposed over" an anode, even though there are various organic layers between the cathode and anode.

In some embodiments, step 310 includes applying a liquid coating, including a volume-reducing material, onto the mold and processing or curing the coating to form the substrate over or on top of the mold. In some embodiments, the substrate can be transparent. In some embodiments, the material and thickness of the coating result in a substrate that is flexible if not supported by the mold. For example, Polyester substrate can be formed by melting the raw material (e.g. purified terephthalic acid (PTA)) and then cooled to form films. The thickness of the film is to be larger than the height of the surface feature H, and has a range from 5 $\mu$m to a few hundred $\mu$m. In some embodiments, volume-reducing material can be used on a mold with topographical features, where areas of greatest deposited material undergo the greatest volume reduction to thereby create specific areas of curvature on the top surface of the resulting substrate, and contact with the mold create specific areas of curvature on the bottom surface of the resulting substrate.

As used herein, a "volume-reducing" material refers to one that can be treated, such as by curing, drying, heating, evaporation, or the like, to result in a cured material that has a reduced volume relative to the volume of material initially deposited prior to the curing. One illustrative volume-reducing material is a polymer dissolved in a solvent, but embodiments are not limited thereto. Once the solvent is processed, cured or otherwise evaporated, the remaining material loses volume and forms a polymer coating on the mold. The resulting polymer coating forms a smooth layer following the contour of the underlying mold surface profile. The portion of the layer with thickest coating material has the most reduction in its thickness, resulting a surface profile that is controllable by coating and curing conditions.

In some embodiments, the substrate is formed directly over the mold without any intervening layers such that the substrate directly contacts the mold. In other embodiments, there can be one or more intervening layers between the mold and the substrate, such as, for example, a release layer.

In some embodiments, the refractive index of the substrate material can have a difference of less than 0.1 or 0.2 from the refractive index of the organic emissive materials. A high refractive index (>1.6) is preferred for better light extraction efficiency. The most preferred refractive index is a value higher than the refractive index of the light generating layer (> 1.7).

Step 320 can include forming an OLED over the substrate while the substrate is attached to the mold. The process for fonning an OLED will be discussed in more detail below. In some embodiments, prior to forming the OLED, a barrier layer is applied over the substrate. In some embodiments, prior to forming the OLED, bus lines can be fabricated over the substrate. Step 330 can include removing the mold from the substrate having the OLED fabricated thereon. The substrate and OLED can be removed from the mold in a number of different ways as described in more detail below.

According to some embodiments of the invention, the substrate can be fabricated to have curvatures on one or both sides and devices can then be built on the substrate, thereby resulting in better light extraction. One side of the substrate (called top side) is non-flat (with curvatures) but has a smooth surface. This is done by casting a volume-reducing substrate material on the mold with topographical features, where areas of greatest deposited material undergo the greatest volume reduction to thereby create specific areas of curvature on the top surface of the resulting substrate, and contact with the mold create specific areas of curvature on the bottom surface of the resulting substrate. This novel substrate can enhance the light extraction of OLED devices.

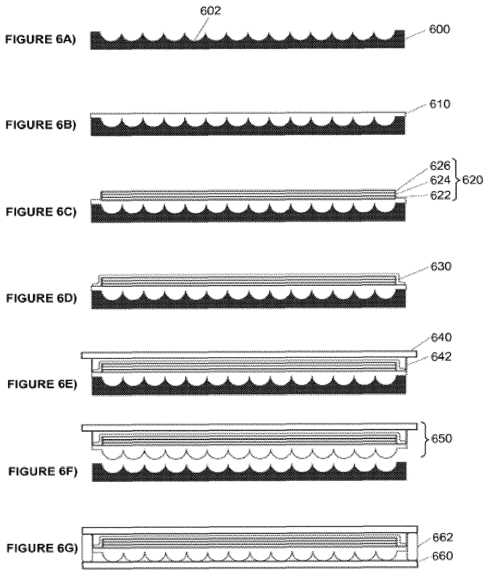

Returning to FIG. 3, step 300 can include providing a mold as discussed above in reference to FIG. 3. As shown for example in FIG. 6A, such a mold 600 can include one or more surface features, for example concave structures 602. As used herein, the term "concave" means a surface that curves inward. For example, the outside surface of a sphere is convex and an inside surface of a sphere is concave. When concave structures 602 are shaped to form microspheres on the substrate, mold 600 may resemble, for example, an empty egg carton.

Step 310 can include forming a substrate over the mold. As shown for example in FIG. 6B, substrate 610 can be thicker than the depth of concave structures 602 so that the top surface of substrate 610 is smooth and continuous. This can overcome the challenge of the mold having a rough surface with random spikes. If the top surface of substrate 610 is not smooth enough, a planarization layer (not shown) can be applied over the substrate. To help prevent any moisture or other detrimental gas/chemicals from migrating into the OLED, a barrier layer (not shown) can be deposited on top of the substrate. This barrier layer can also protect the underlying substrate layer when chemicals are used in the following steps (e.g., in a photolithography process).

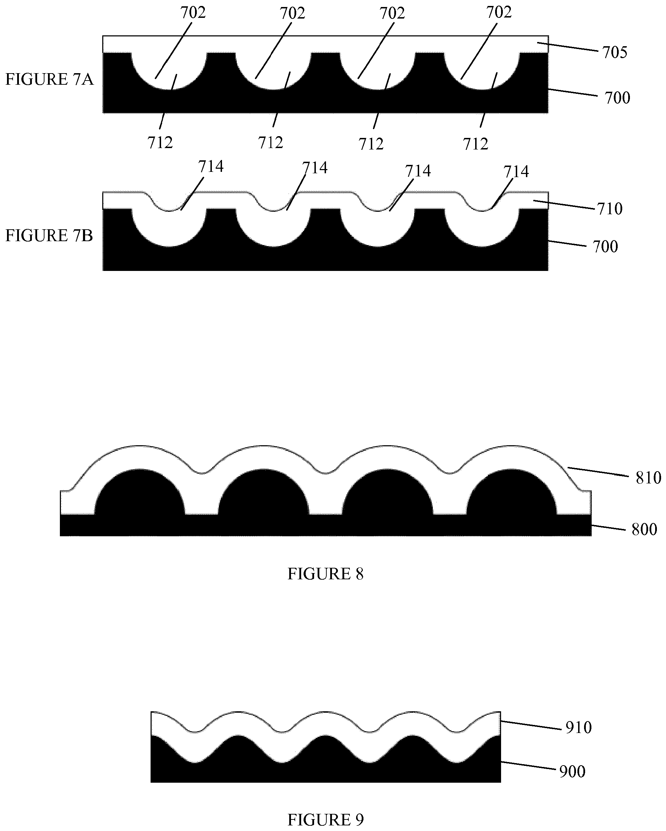

However, where the top side of the substrate is to be non-flat (with curvature) but have a smooth surface as shown in FIG. 7B, a volume-reducing, conforming substrate material 705 can be cast on the mold 700 with topographical features where areas 712 of greatest deposited material undergo the greatest volume reduction to thereby create specific areas 714 of curvature on the top surface of the resulting conformal substrate 710 and contact with the mold create specific areas of curvature on the bottom surface of the resulting conformal substrate 710. In the illustrated embodiment, the areas 712 of greatest material also serve to form the specific areas of curvature on the bottom surface of the conformal substrate 710, in this case, spherical lens features, but embodiments are not limited thereto. This novel conformal substrate 710 can enhance the light extraction of OLED devices.

In the embodiment illustrated in FIGS. 7A and 7B, the volume-reducing material is first coated on top of the mold 700. One illustrative material is a polymer dissolved in a solvent, but embodiments are not limited thereto. Once the solvent is processed, cured or otherwise evaporated, the coating loses volume and forms a polymer coating. The resulting coating forms a smooth layer following the contour of the underlying mold 700 surface profile. The portion of the layer with thickest coating material has the most reduction in its thickness, resulting a surface profile that is controllable by coating and curing conditions, as shown in FIG. 7B.

OLEDs can then be fabricated on top of the curved conformal substrate 710 in a manner substantially identical to the OLED fabrication on top of the flat substrate 610 shown in FIGS. 6A-6G. As described in greater detail below, the OLEDs can be fabricated to include some or all of a barrier layer, anode layer, metal bus lines, HIL (hole injection layer), HTL (hole transport layer), EML (emissive layer), HBL (hole blocking layer), EIL (electron injection layer), ETL (electron transport layer), and EBL (electron blocking layer), cathode, barrier layers, and protection layers. The entire device stack, together with the conformal substrate 710 with curvatures on both sides, can be released from the mold 700 after device fabrication. The conformal substrate 710 can also be released from the mold 700 without device fabrication to be used as a stand-alone component.

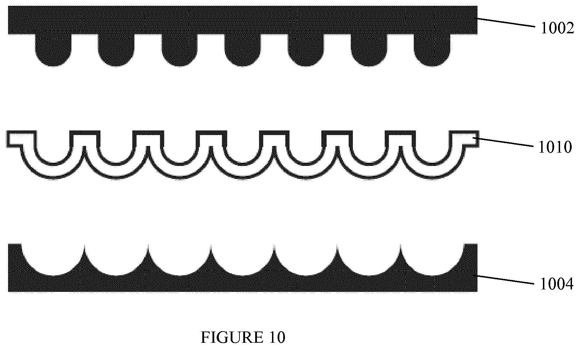

The molds 600, 700 in FIGS. 6A-6G, 7A and 7B have semi-spherical features 602, 702 indented into the volume-reducing substrate material (i.e., 705) but embodiments are not limited thereto, and the surfaces of molds 600, 700 can be any shape. FIG. 8 is a sectional view of another mold 800 with semi-spherical features and resulting in a substrate 810 with topographical features or curvatures on both sides of the substrate. FIG. 9 is a sectional view of another mold 900 with sine function shape features also resulting in a substrate 910 with topographical features or curvatures on both sides of the substrate. FIG. 10 is a sectional view of another mold 1002 and 1004 with micro-well features also resulting in a substrate 1010 with topographical features or curvatures on both sides of the substrate.

A benefit of using substrates with curvatures on both sides is improved light extraction. For example, when a curved substrate is used, especially with a high index of refraction, the light extraction can reach as high as 100% for the substrate mode wave-guided light. The embodiments of the present invention achieve similar results and provide a much smoother surface.

In a further embodiment, the substrate has a pre-defined, overall non-planar profile shape, and the first organic light emitting device includes a final profile shape conforming to the pre-defined overall non-planar profile shape of the substrate. Current OLED devices are planar when they are initially formed, excluding those using flexibility to be later formed into any desired non-planar shape. In embodiments of the present invention, the substrate can be any pre-defined, overall non-planar profile shape, such as rod shaped, cube shaped, ball shaped and so forth. The first organic light emitting device is constructed on the substrate to have a final profile shape conforming to the pre-defined overall non-planar profile shape of the substrate. There are many benefits to such an arrangement. For example, in most of these cases, the outer area of the device will be larger than the inner area of the device. Accordingly, the outer area can be used to provide "blue" colors, since the larger area can compensate for lifetime losses. Individual devices can also be made into a one single device having multi display or lighting surfaces. For example, a globe shaped device can be formed that may have an almost perfect outcoupling yield.

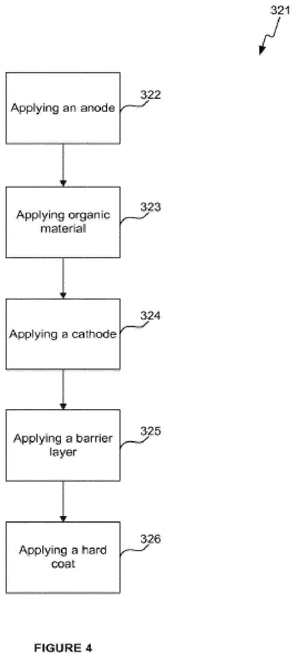

OLEDs can then be fabricated on top of the curved conformal substrate 710, or the conformal substrate 710 can be released from the mold 700 without device fabrication to be used as a stand-alone component. FIG. 4 illustrates an illustrative OLED fabrication process 321 that can be used in step 320 of FIG. 3 to fabricate an OLED. Process 321 can include a step 322 of applying an anode, a step 323 of applying organic material, a step 324 of applying a cathode, a step 325 of applying a barrier layer, and a step 326 of applying a hard coat. Fabrication process 321 is merely illustrative and can include additional steps or fewer steps. For example, it can also include steps for forming layers present in OLED device 100 or 200, but not specified in fabrication process 321. The order of steps can also be rearranged. For example, if an inverted OLED, such as that described in reference to FIG. 2, is desired, then steps 322 and 324 can be reordered.

Step 322 can include applying an anode over the substrate. Any suitable method can be used including, but not limited to, sputtering, photolithography, and other wet or dry processes. Step 323 can include then applying organic material over the anode. The organic material can include one or more layers of suitable material including, but not limited to, HIL (hole injection layer), HTL (hole transport layer), EML (emissive layer), HBL (hole blocking layer), EIL (electron injection layer), ETL (electron transport layer), and EBL (electron blocking layer). The organic material can be applied using any suitable method including, but not limited to thermal evaporation, ink-jet printing, organic vapor phase deposition (OVPD), deposition by organic vapor jet printing (OVJP), spin coating and other solution based processes. Step 324 can include then applying a cathode over the organic material. Any suitable method can be used including, but not limited to, sputtering, photolithography, and other wet or dry processes.

Step 325 can include applying a barrier layer over the OLED to encapsulate the OLED. In some embodiments, the barrier layer is a thin film so that the OLED is flexible. The barrier layer can include inorganic, organic, and hybrid materials. The application process can include, but is not limited to, sputtering, plasma-enhanced chemical vapor deposition (PECVD), atomic layer deposition (ALD), and other thin film deposition processes. Step 326 can include then applying a hard coat layer such as plastic films over the barrier layer to provide extra protection to the OLED. In addition to providing a mechanical protection layer, the hard coat layer can facilitate removing the mold from the substrate and OLED device.

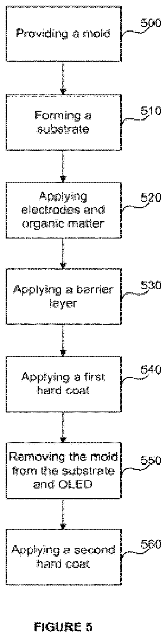

FIG. 5 is an illustrative flowchart of a method for fabricating a flexible OLED on a substrate which can include one or more of the steps previously described in reference to FIGS. 3 and 4. The method can include a step 500 of providing a mold, a step 510 of forming a substrate, a step 520 of applying electrodes and organic matter, a step 530 of applying a barrier layer, a step 540 of applying a first hard coat, a step 550 of removing the mold from the substrate and OLED, and a step 560 of applying a second hard coat The method of FIG. 5 is merely illustrative and can include additional or fewer steps. The order of steps can also be rearranged. A more detailed discussion of each of the steps follows, along with a discussion of accompanying FIGS. 6A-6G, which illustrates views of transient structures formed after each step of the method outlined in FIG. 5.

Step 500 can include providing a mold and can correspond to step 300 discussed above in reference to FIG. 3. Step 510 can include forming a substrate over the mold and can correspond to step 310 as discussed above in reference to FIG. 3. In some embodiments, as shown for example in FIG. 6B, substrate 610 can be thicker than the depth of concave structures 602 so that the top surface of substrate 610 is smooth and continuous. In some embodiments, as shown for example in FIGS. 7A and 7B, the volume-reducing substrate material 705 can be cast on the mold 700 with topographical features, where areas 712 of greatest deposited material undergo the greatest volume reduction to thereby create specific areas 714 of curvature on the top surface of the resulting conformal substrate 710, and contact with the mold create specific areas of curvature on the bottom surface of the resulting substrate.

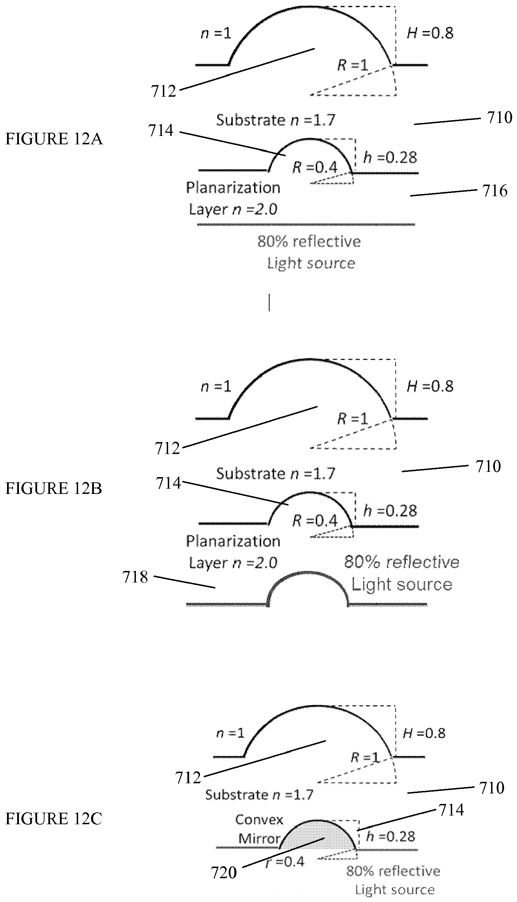

In some embodiments, the specific areas of curvature 714 on the top surface of the conformal substrate 710 can be filled with a planarization material possessing a refractive index greater than or equal to a refractive index of the substrate prior to forming the OLED as shown in FIG. 12A. In other embodiments, the specific areas of curvature 714 on the top surface of the conformal substrate 710 can be filled with a conformal coating or material possessing a refractive index greater than or equal to a refractive index of the substrate and which maintains some of the topography of the areas of curvature 714 prior to forming the OLED as shown in FIG. 12B. In still other embodiments, the specific areas of curvature 714 on the top surface of the conformal substrate 710 are metallized to form convex mirrors prior to forming the OLED as shown in FIG. 12C. Also, to help prevent any moisture or other detrimental gas/chemicals from migrating into the OLED, a barrier layer (not shown) can be deposited on top of the conformal substrates 610, 710. This barrier layer can also protect the underlying substrate layer when chemicals are used in the following steps (e.g., in a photolithography process).

Step 520 can include applying the electrodes and organic matter and can correspond to steps 322, 323, and 324 discussed above in reference to FIG. 3. In some embodiments, as shown for example in FIG. 6C, an OLED 620 can be formed comprising two electrodes 622 and 626 with organic material 624 sandwiched between electrodes 622 and 626. One or more OLEDs 620 can be formed on conformal substrates 610, 710. In some embodiments, OLED 620 can be a bottom emission OLED such that electrode 622 is an anode and electrode 626 is a cathode. In some embodiments, anode 622 is transparent and can be applied over conformal substrates 610, 710 according to any of the methods discussed above with respect to step 322. In some embodiments, anode layer 622 can be patterned and/or can include extra bus lines to help distribute current. In such instances, anode layer 622 can include insulating material for patterning and/or extra conductive materials for the extra bus lines. These can be formed using standard photolithography processes or other wet or dry processes. After anode layer 622 is formed, one or more organic layers 624 can be fonned over anode layer 622 in accordance with the processes discussed above with respect to step 323. Next, cathode layer 626 can be formed over organic layers 624 in accordance with the processes discussed above with respect to step 324. In some embodiments, additional layers can be deposited over cathode 626. For example, a buffer layer (not shown) can be deposited over cathode 626.

Step 530 can include applying a barrier layer and can correspond to step 325 as discussed above in reference to FIG. 3. In some embodiments, as shown for example in FIG. 6D, a barrier layer 630 is deposited over OLED device 620 and can include oxide, nitride, ceramic, or hybrid materials. In some embodiments, barrier layer 630 is sufficiently thin in thickness so that the OLED device is flexible. Step 540 can include then applying a hard coat and can correspond to step 326 as discussed above in reference to FIG. 3. In some embodiments, as shown for example in FIG. 6E, a hard coat 640 can be attached to barrier layer 630 via a glue layer 642. In some embodiments, hard coat 640 has barrier properties to prevent exposure to harmful species in the environment including moisture, vapor and/or gases. Materials for hard coat 640 can include, but are not limited to, glass, metal foil, or a barrier coated plastic film.

In some embodiments, after step 520, 530 or 540, as shown for example in FIGS. 6C-6E, respectively, a transient structure exists including the mold having surface features, a substrate formed over the mold, and an OLED fabricated over the substrate. As discussed above, conformal substrates 610, 710 can be transparent and can have a thickness such that the substrate is flexible in the absence of the mold. Such a transient structure exists during manufacturing and in some embodiments can be shipped or stored in this state before the remaining steps of the process, such as removal of the mold, are performed.

Step 550 can include removing the mold from the substrate and OLED, and can correspond to step 330 discussed above in reference to FIG. 3. In some embodiments, as shown for example in FIG. 6F, an assembly 650 of OLED 620 and substrate can be removed from the mold. The release step can be performed using a variety of different means. In some embodiments, removal involves an application of force to separate mold from assembly 650. As long as the adhesion between conformal substrate 610, 710 and mold 600, 700 is the weakest among all interfaces, the substrate will be detached from the mold.

In some embodiments, the mold is dissolved, thereby removing the mold from assembly 650. For example, a mold can be made by forming topographical features using photoresist on a flat piece of glass. Photoresist is a standard material used for patterning purposes in photolithography processes, and can be easily removed afterwards. For example, a typical positive resist S1813, provided by Shipley, may be dissolved in acetone before hard baking. Even after hard baking, such as 150°C baking, S1813 may still be removed by photoresist remover 1165, provided by Shipley, at an elevated temperature.

In some embodiments, a thermal approach can be taken to perform the removal. For example, assembly and mold can be heated and/or cooled. As a result of any mismatch of thermal expansion of mold and substrate material, the substrate can be separated from the mold. The coefficient of thermal expansion (CTE) values of some of the material used for the mold and substrate are shown in Table 2. Typical plastic materials have very large CTE values. When paired with a mold made out of low CTE materials (e.g., Si, glass, stainless, or steel), the plastic materials can be easily released from the mold by cooling the entire component, such that the plastic shrinks substantially more than the mold and as a result separates itself from the mold.

For example, assume a 100 $\mu$m thick substrate coating is applied on top of the mold at room temperature. The CTE mis-match is about $50 \times 10^{-6}$ / K (plastic on glass/Si mold). When the whole component is cooled down 20 degrees Kelvin, the dimension change between the substrate and mold is $100 \times 50 \times 10^{-6} \times 20 = 0.1$ $\mu$m, which is a significant change and can cause the separation of the substrate from the mold.

Table 2

| Material | Si | Glass | Stainless Steel | Typical plastic |
|---|---|---|---|---|
| CTE (ppm/K) | 3 | 3~9 | 17 | 40~70 |

A light source can also be used to trigger the release of the substrate. Ultraviolet, infrared or visible light sources, including lasers, can be used to locally heat up the interface between substrate and mold. To facilitate this process, a release coating (not shown) which absorbs the photoenergy, can be deposited over the before forming conformal substrates 610, 710 between steps 500 and 510. Oxide material such as $SiO_2$, $Al_2O_3$ and transparent conductive oxide material ITO can be used to convert light to heat. The thickness of the applied material can range from a few nm to 100 nm.

In some embodiments, a low adhesion between substrate and mold can be achieved by treating the mold surface such that it has a low surface energy using, for example, the application of a release coating to the mold between steps 500 and 510. The low surface energy release coating can include, but is not limited to, fluorinated polymers (e.g., Teflon), siloxanes, or silicones. In some embodiments, when the mold is Si (e.g., oxidized Si) or glass, the low surface energy release coating can be fluorinated silane.

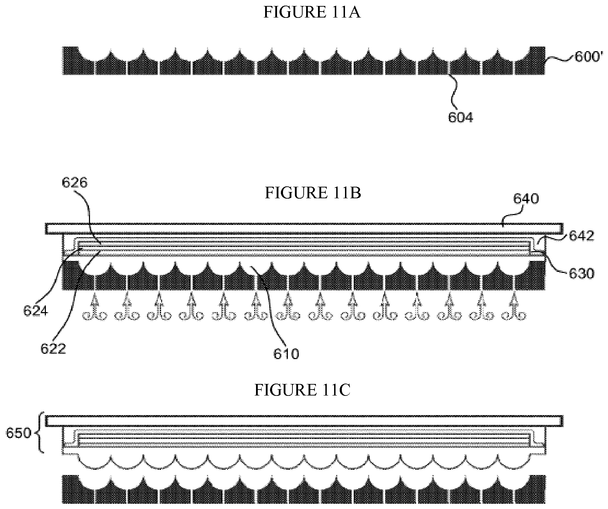

In some embodiments, a liquid or gas can be used to remove the mold from the assembly of the OLED device and substrate. As shown in FIGS. 11A to 11C, a mold 600' can have a plurality of holes 604 extending through the entire thickness of the mold. These or similar holes can provide access to conformal substrates such as 610, 710 from the backside of the mold. During removing step 550, a liquid or gaseous substance, for example a chemical or water (either in the liquid or gas forms), can travel through the holes and change the interface adhesion between conformal substrate 610, 710 and mold to facilitate removal of the mold from the assembly 650. In other embodiments, a mechanical force can be applied through the holes. This mechanical force can be applied, for example, by using, a solid substance (e.g., pins), a liquid substance (e.g., a hydraulic liquid) or gaseous substance. One example of using gas can include sending a high pressure gas through the holes to push conformal substrate 610, 710 off the mold.

In some embodiments, the dimension of the holes are sized to ensure they are not too large in order to avoid decreasing the effective lens surface and to minimize the substrate from leaking through the holes when the substrate is formed. In some embodiments the holes take less than 10% of the base area of each individual lens. For example, for a hemispherical lens with a radius of 5 $\mu$m, the hole radius should be less than 1.6 $\mu$m. It can be preferred to have a very small hole such that the coating will not fill into the through hole due to the surface tension of the coated material. For standard photolithography process, a sub-micron size (e.g., 0.5 $\mu$m) is possible with an ultraviolet light source. The surface of the mold can be treated to facilitate this process.

In some embodiments, once the mold is removed, the substrate having the OLED fabricated thereon is flexible. For example, in some embodiments, the substrate having the OLED fabricated thereon can have a flexural rigidity sufficiently low that the substrate can be wrapped around a 12-inch diameter roll without breaking.

In some embodiments, as shown for example in FIG. 6F, once the mold is removed, the substrate includes bottom surface features complementary or conforming to the surface features of the mold from which it was removed. For example, a spherical indentation in the mold will lead to a complementary or conforming spherical bulge on the substrate of similar radius. As used herein, "complementary" and "conforming" allow for minor differences caused, for example, by the presence of a release layer having some thickness and irregularity between the substrate and the mold. In some embodiments, at least some of the surface features on the substrate are convex.

The substrate can further include substrate top surface features that are complementary to the sub s t rat e bottom surface features. For example, the spherical bulge on the bottom surface of the substrate will lead to a complementary spherical dimple on the top surface of the substrate of similar position and having features based on a composition of a volume-reducing substrate material.

Turning back to FIG. 5, step 560 can include applying a second hard coat after step 550 to the outcoupling side of the device to provide extra mechanical protection and barrier protection. In some embodiments, as shown for example in FIG. 6G, a hard coat 660 can be applied to the substrate. A thin piece of glass or a barrier coated plastic can be used for hard coat 660. In some embodiments, hard coat 660 can have an anti-reflective coating on both sides. Hard coats 640 and 660 can be attached together by a glue layer 662. In some embodiments, glue layer 662 is flexible and has barrier properties. A desiccant material can be included inside the assembly between hard coats 640 and 660 to provide extra protection from moisture and oxygen.

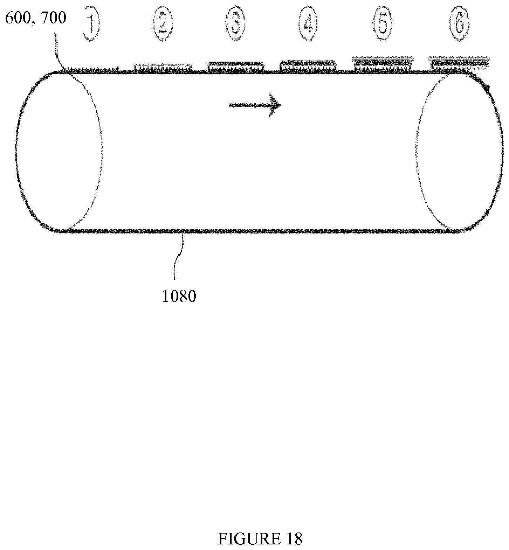

In some embodiments, steps 500 through 550 can occur on a conveyor belt apparatus as shown for example, in FIG. 18. Stations 1 through 6 correspond with steps 500 through 550, respectively, and with the structures shown in FIGS. 6A-6F, respectively. In such embodiments, a flexible mold 600, 700 is preferred. In some embodiments, mold 600, 700 can be attached to a conveyor belt 1080 and as the mold moves with the conveyor belt, different materials will be deposited on the mold. In other embodiments, the conveyor belt 1080 can be the mold 600, 700. At the end of the process, the mold will bend around the roller and when the substrate-mold interface is the weakest interface, the assembly of the substrate and the OLED will peel off from the mold. In such embodiments, the mold is preferred to be more flexible than the assembly of the substrate and the OLED. This is because the hard coat makes the assembly more rigid than the mold. In such embodiments, the mold can be made out of thinner materials so it can bend around the rollers of the conveyor belt.

In such embodiments, the corresponding apparatus can include belt 1080; a mechanism to move the belt, which can be any conventional belt driving means; and a flexible mold disposed on the belt, wherein the flexible mold has surface features. The apparatus can also include the following in sequential order along a path of the belt: a dispenser attached to a source of substrate material; an energy source adapted to treat the substrate material, including the processing, removal and/or evaporation of the solvent of the substrate coating to result in the desired volume reduction of the substrate; a plurality of dispensers attached to sources for applying the materials making up the components of the OLED; and a mechanism adapted to remove the assembly of the substrate material and OLED from the mold disposed on the belt. In some embodiments, as discussed above, the mechanism adapted to remove the assembly can hold the OLED device as the substrate peels from the mold when the belt bends around the rollers.

In order to create a dimple formation on the top surface of the conformal substrate 710 by volume reduction on the mold, one embodiment uses a 14% weight ratio of poly (methyl methacrylate) that is well mixed with toluene. The mixture of solid and solvent can be stirred with a magnetic bar for 1 hour to yield a homogeneous coating fluid. The mold 700 used here can be a nickel plate microlens mold with inverse hemisphere patterns at 50 $\mu$m in diameter. A release agent is applied to the MLA mold surface before coating to ensure easy substrate release. Once the coating is done, the coated plate can be processed, cured or heated to remove a desired amount of solvent, such as by placing the coated plate on a hot surface at 110°C for 30 minutes to drive the solvent out of substrate. Due to the volume shrink associated with the inverse MLA features on the mold, the top surface of the substrate demonstrates dimple patterns while the bottom surface of the substrate demonstrates a microlens array replicated from the master mold. The above formation operations can occur on the conveyor belt apparatus as shown in FIG. 18 and are provided by way of example, and the present invention is not limited thereto.

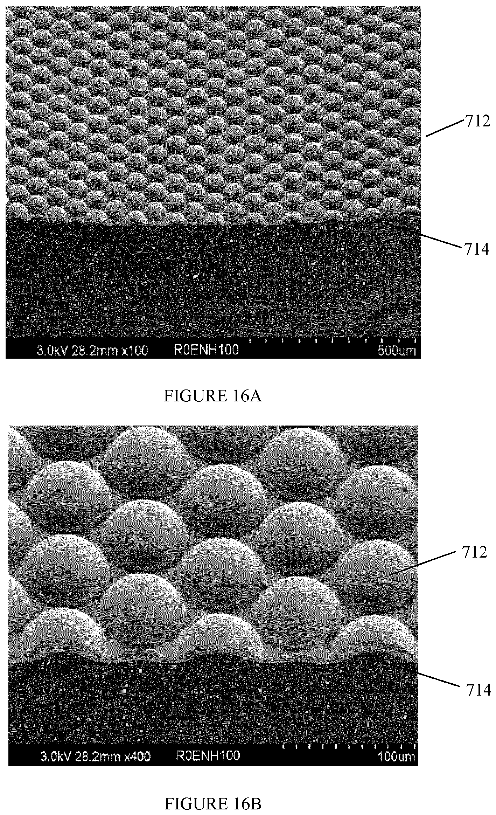

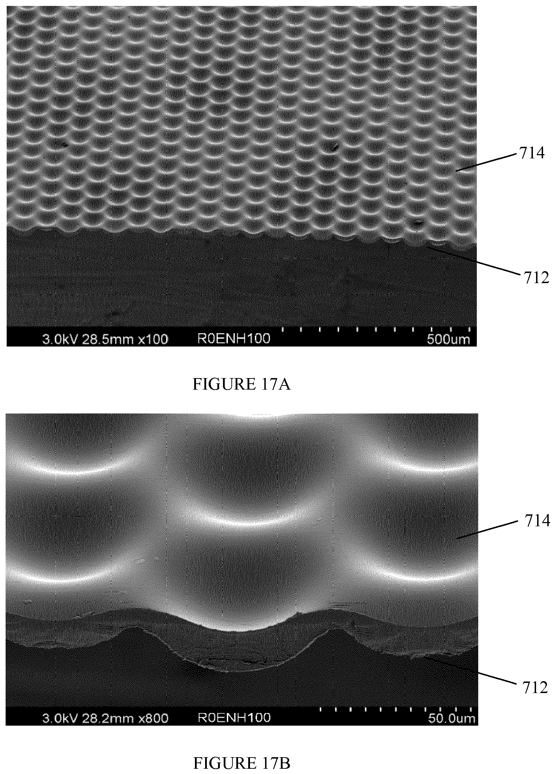

FIGS. 16A and 16B are SEM images of the topographical features or curvatures on the bottom surface of the conformal substrate 710, and FIGS. 17A and 17B are SEM images of the topographical features or curvatures on the top surface of the substrate. The microfeatures formed on the bottom surface of the conformal substrate 710 accurately replicate the shape of the mold 700. The hemisphere of each microlens is around $50\mu$m in diameter, wherein only one microlens is labeled for clarity. Due to the nature of solvent evaporation in the curing process, the top surface of the conformal substrate 710 forms well-ordered, dimple patterns of FIGS. 17A and 17B, following the curvature of the inverse microlens surface of FIGS. 16A and 16B. The radius of each dimple pattern is less than the radius of the microlens formed on the bottom of the conformal substrate 710, wherein only one dimple is labeled for clarity. By controlling the loading ratio of solid in the solution, various geometry of dimple pattern can be easily obtained.

As noted above, thin, microlens-bearing plastic substrates can be fabricated by casting a dissolved polymer film over the mold containing a pattern of microwells. The polymer film loses volume as the solvent evaporates and it cures into a solid. This creates a dimple or other shape typically centered on the axis of each microlens on the free side of the film or conformal substrate 710. In one embodiment, the dimple 714 can be filled with a planarization material or layer 716 possessing a high index of refraction as shown in FIG. 12A. FIG. 12A is a sectional view illustrating a substrate surface curvature or dimple that can be filled with a planarization material possessing a refractive index greater than or equal to a refractive index of the substrate.

This additional non-planar refractive interface formed between the cast substrate and planarization layer acts as in internal extraction layer. Ray tracing simulations show that the outcoupling efficiency $\eta_0$ of a microlens substrate with index of refraction $n$ =1.7 can be improved to $\eta_0$=39% by planarizing dimples on the device side of the conformal substrate 710 with a material for which $n$ =2.0. This compares to $\eta_0$=33% where the planarizing coating abutting the OLED has a refractive index matched to the substrate. The neighbor spacing of the MLA is $R$ =1 center-to-center. The radius of curvature of the microlenses is also $R$ =1 and an aspect ratio of $H/R$ =0.8, where $H$ is the prominence of the microlens apex above the substrate plane. The lenses of the internal extraction layer are coaxial with those of the external extraction layer, and have radius $r$ =0.4 and aspect ratio $h/r$ =0.7, where $h$ is the prominence of the internal extraction layer features. For comparison, a substrate with a refractive index of $n$ =1.7 and both planar device and air interfaces has an outcoupling efficiency $\eta_0$ =19%.

The applied high index material may not planarize the dimples on the device side of the conformal substrate 710 in some embodiments. The device side of a substrate surface coated with a conformal high index coating 718 maintains the topography of the dimpled conformal substrate 710 as shown in FIG. 12B. Organic light emitting devices do not require flat growth substrates, so it is therefore possible to grow an emissive structure 718 over the dimpled conformal substrate 710 surface. Conformal deposition of organic device layers can be promoted using techniques such as organic vapor phase deposition (OVPD). A potential advantage of such a structure is a greater emissive surface area per cross sectional area of the device. It also offers improved outcoupling when compared with a device grown on over a planarized IEL. Ray trace modeling indicates $\eta_0$ of 43% can be achieved if the dimples in the previous case are conformally coated with a high index material with refractive index n=2.0 as shown in FIG. 12B. The simulation assumes the same substrate 710 geometry as the previous case. In this case, the high index material layer 718 disposed between the substrate and the thin film layers of the OLED is a conformal coating rather than a planarization layer. The surface adjacent to the OLED layers features a dimple with dimensions identical to that on the substrate 714 underneath it, such that r'=0.4 and aspect ratio $h'/r'$=0.7. Conformal coating 718 has a refractive index of 2.0.

The high index layer may have a shape intermediate between that of a planarization layer 716 and a conformal coating 718. Such a coating partially planarizes a substrate so that the dimples on the OLED deposition surface are reduced but not eliminated, $h'<h$. The optical performance of such a structure is intermediate between that of a structure with a planarization layer and that of structure with a conformal high index layer. There are manufacturing advantages to such a structure. Total planarization of the substrate may be difficult to achieve, while partial planarization may be sufficient to facilitate conformal deposition of OLED materials over the substrate surface.

The dimples present on a microlens array substrate cast from volume reducing material can also be used as a basis for internal outcoupling structures comprised of reflectors disposed over the substrate. For example, if the dimpled portions of the conformal substrate 710 is metallized, the reflective surface deposited on the dimple forms a convex mirror 720 when viewed from the microlens 712 bearing side of the substrate as shown in FIG. 12C. The convex mirrors do not emit light, and they are not covered by a functional OLED surface, however the cathode layer of the OLED can serve as their metallization. Light from this structure is generated by OLED layers deposited on the planar substrate surface surrounding the convex mirrored dimples.

The convex mirrors 720 can redirect light rays propagating through the substrate close to the substrate plane towards the normal direction. This increases the efficiency with which these rays can be outcoupled when they encounter the substrate-air interface. The outcoupling efficiency of a hexagonally packed array spherical microlens array with radius $R$ =1 and aspect ratio $H/R$=0.8 can be increased from 33% to 59% with the incorporation of convex mirrors coaxial to the microlenses on the opposing surface of the substrate. The mirrors are assumed to have a radius $r$=0.4 and an aspect ratio of $h/r$=0.7, where $h$ is the prominence of the convex mirror apex above the plane of the OLED.

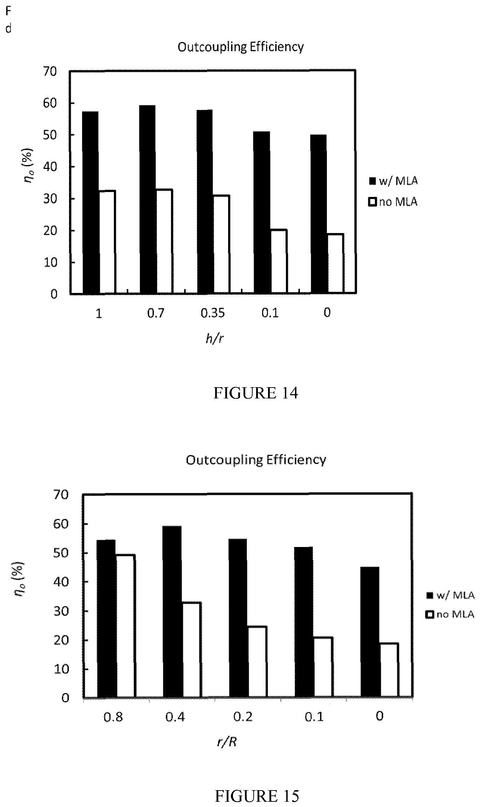

Although the dimples used to form the mirrors can be formed as a byproduct of microlens array fabrication, the convex mirror array does not require a microlens array to improve outcoupling from a substrate. A hexagonal convex mirror array with a nearest neighbor spacing of $R$=1, radius r=0.4 and aspect ratio $h/r$ =0.7 can increase outcoupling $\eta_0$ of a substrate from 19% to 33%. The effectiveness of convex mirror outcouplers depends on $h/r,$ as shown in FIG. 14. Less prominent features, such as $h/r$ =0.1, are inefficient outcouplers, while higher aspect ratio features, $h/r$ >0.35 are more effective. Optimal aspect ratio is approximately $h/r$ =0.7 for cases both with and without a microlens array.

The outcoupling of the convex mirror array also depends on the mirror's radius of curvature for a given aspect ratio as shown in FIG. 15. If the substrate-to-air interface is planar, larger convex mirrors generate better outcoupling efficiency. For the case of a hexagonal array of convex micromirrors with $h/r$ =0.7 and $R$ =1, an outcoupling efficiency of 49% can be achieved for mirrors of $R$ =0.8. Outcoupling efficiency declines for smaller convex mirrors with the same center-to-center spacing, since they cover less of the substrate surface area and the array has a lower fill factor. A smaller radius of curvature is preferred if an array of convex mirrors are used coaxially with a microlens array. If the radii of the microlenses and convex micromirrors are similar, planes tangent to the outcoupling features on corresponding points from the front and rear sides of the substrate are nearly parallel with each other. This diminishes the effectiveness of both outcoupling surfaces, since the substrate becomes locally planar from the perspective of light traveling within it. A configuration such that $r$ =0.4 appears to be optimal for a microlens array with $R$ =1.

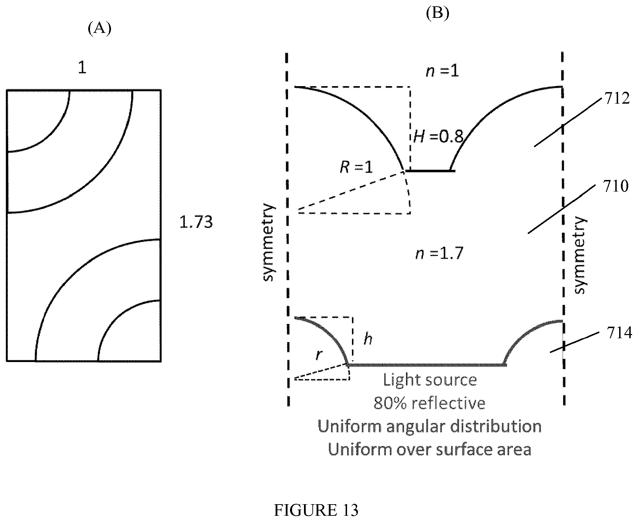

Outcoupling is modeled in TracePro (Lambda Research, Littleton, MA) by raytracing. A hexagonally packed microlens array on the substrate is treated as a simple repeating cell with symmetry boundary conditions at its interfaces with neighboring cells on four sides as shown in FIG. 13. View (A) of FIG. 13 is a plan view of a cell of the simulated substrate. The microlens 712 has radius R=1.0. The cell has dimensions 1.73 by 1.0. Lengths are expressed in non-dimensional units because the ray tracing method is independent of length scale.

View (B) of FIG. 13 is a sectional view of the simulated cell. All simulated devices assumed a substrate with an index of refraction n=1.7. All reflective surfaces, including both the convex mirrors and the OLED cathode have a reflectivity of 80%. The angular distribution of rays from every point of a light emitting surface was assumed to be uniform over a hemisphere with a base tangent to the surface at that point. The intensity of light from light emitting surfaces were assumed to be spatially uniform.

Devices fabricated in accordance with embodiments of the invention may be incorporated into a wide variety of consumer products, including flat panel displays, lighting devices, computer monitors, medical monitors, televisions, billboards, lights for interior or exterior illumination and/or signaling, heads up displays, fully transparent displays, flexible displays, laser printers, telephones, cell phones, personal digital assistants (PDAs), laptop computers, digital cameras, camcorders, viewfinders, micro-displays, 3-D displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18°C to 30°C, and more preferably at room temperature (20°C to 25°C), but could be used outside this temperature range, for example, from -40°C to +80°C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

It is to be appreciated that the Detailed Description section, and not the Summary and Abstract sections, is intended to be used to interpret the claims. The Summary and Abstract sections may set forth one or more but not all illustrative embodiments of the present invention as contemplated by the inventor(s), and thus, are not intended to limit the present invention and the appended claims in any way.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning of the claims.

It is to be understood that the phraseology or terminology herein is for the purpose of description and not limitation, such that the terminology or phraseology of the present specification is to be interpreted by the skilled artisan in light of the teachings and guidance.

**Claims**

1. A method of fabricating a light emitting device, comprising:

    depositing a volume-reducing material over a surface of a mold having surface features thereon;
    curing the volume-reducing material to form a conformal substrate over the surface of the mold, the conformal substrate having a profile defined by the surface features of the mold, wherein the bottom substrate surface features of the conformal substrate are a result of direct mold surface contact and are spherical or aspherical lenses, and the top substrate surface features of the conformal substrate are dimple features complementary to the curvature of the features on the bottom substrate surface; and
    forming an OLED over the conformal substrate while the substrate is disposed over the surface of the mold.

2. The method of claim 1, further comprising removing the conformal substrate from the surface of the mold, wherein the device is flexible after removing the conformal substrate from the surface of the mold.

3. The method of claim 1 or 2, wherein the volume-reducing material comprises:

    a polymer dissolved in a solvent, wherein the step of curing the volume-reducing material comprises evaporating the solvent from the volume-reducing material, and
    wherein the top surface of the conformal substrate conforms to the bottom surface of the substrate after curing, in response to an applied volume of volume-reducing material and a ratio of polymer to solvent of the applied volume-reducing material.

4. The method of any one of the previous claims, wherein the OLED has a profile conforming to the shape of the substrate.

5. The method of any one of the previous claims, wherein the surface features comprise a plurality of microwells.

6. The method of any one of the previous claims, further comprising applying a planarization layer onto the top surface of the conformal substrate, wherein the planarization layer has a refractive index greater than or equal to a refractive index of the conformal substrate.

7. The method of any one of the previous claims, further comprising applying a reflective material over concave features on the top surface of the conformal substrate that are not covered by the OLED.

8. The method of any one of the previous claims, further comprising applying a barrier layer over the OLED.

9. The method of any one of the previous claims, wherein the step of forming the OLED comprises depositing at least one layer using organic vapor phase deposition (OVPD).

10. A light emitting device, comprising:

    a substrate having surface features on its bottom surface and top surface, wherein the bottom substrate surface features are spherical or aspherical lenses, and the top substrate surface features are dimple features complementary to the curvature of the features on the bottom substrate surface; and
    an OLED, formed over the top surface of the substrate, wherein the OLED has a profile conforming to the shape of the substrate, wherein the substrate consists of a volume-reducing polymer, and the thickness of the substrate is larger than peak-to-trough height of substrate surface feature, and has a range from 5 $\mu$m to a few hundred $\mu$m.

11. The device of claim 10, wherein the volume-reducing material is a soluble polymer.

12. The device of any one of claims 10 to 11, further comprising a planarization layer applied to the top surface of the substrate, wherein the planarization layer has a refractive index greater than or equal to a refractive index of the substrate.

13. The device of any one of claims 10 to 12, further comprising a reflective material applied over concave features on the top surface of the substrate that are not covered by the OLED.

**14.** The device of any one of claims 10 to 13, further comprising a barrier layer applied over the OLED.

**15.** The device of any one of claims 10 to 14, wherein the device is flexible.

**Patentansprüche**

**1.** Verfahren zum Herstellen einer lichtemittierenden Vorrichtung, welches umfasst:

Ablagern eines volumenreduzierenden Materials über einer Oberfläche einer Form mit Oberflächenmerkmalen auf derselben;
Aushärten des volumenreduzierenden Materials, um ein konformes Substrat über der Oberfläche der Form auszubilden, worin das konforme Substrat ein Profil aufweist, das durch die Oberflächenmerkmale der Form definiert wird, wobei die Oberflächenmerkmale des unteren Substrats des konformen Substrats ein Ergebnis des direkten Kontakts mit der Oberfläche der Form sind und sphärische oder asphärische Linsen sind, und die Oberflächenmerkmale des oberen Substrats des konformen Substrats Vertiefungsmerkmale sind, die komplementär zur Krümmung der Merkmale auf der unteren Substratoberfläche sind; und
Ausbilden einer OLED über dem konformen Substrat, während das Substrat über der Oberfläche der Form angeordnet ist.

**2.** Verfahren nach Anspruch 1, welches ferner das Entfernen des konformen Substrats von der Oberfläche der Form umfasst, worin die Vorrichtung nach dem Entfernen des konformen Substrats von der Oberfläche der Form flexibel ist.

**3.** Verfahren nach Anspruch 1 oder 2, wobei das volumenreduzierende Material umfasst:

ein in einem Lösungsmittel gelöstes Polymer, wobei der Schritt des Aushärtens des volumenreduzierenden Materials das Verdampfen des Lösungsmittels aus dem volumenreduzierenden Material umfasst, und wobei sich die obere Oberfläche des konformen Substrats nach dem Aushärten an die untere Oberfläche des Substrats anpasst, und zwar als Reaktion auf ein aufgebrachtes Volumen des volumenreduzierenden Materials und einem Verhältnis von Polymer zu Lösungsmittel des aufgebrachten volumenreduzierenden Materials.

**4.** Verfahren nach einem der vorstehenden Ansprüche, worin die OLED ein Profil aufweist, das der Form des Substrats entspricht.

**5.** Verfahren nach einem der vorstehenden Ansprüche, worin die Oberflächenmerkmale mehrere Mikrovertiefungen umfassen.

**6.** Verfahren nach einem der vorstehenden Ansprüche, welches ferner das Aufbringen einer Planarisierungsschicht auf die obere Oberfläche des konformen Substrats umfasst, worin die Planarisierungsschicht einen Brechungsindex aufweist, der größer oder gleich einem Brechungsindex des konformen Substrats ist.

**7.** Verfahren nach einem der vorstehenden Ansprüche, welches ferner das Aufbringen eines reflektierenden Materials über konkaven Merkmalen auf der oberen Oberfläche des konformen Substrats umfasst, die nicht von der OLED bedeckt sind.

**8.** Verfahren nach einem der vorstehenden Ansprüche, welches ferner das Aufbringen einer Sperrschicht über der OLED umfasst.

**9.** Verfahren nach einem der vorstehenden Ansprüche, wobei der Schritt der Ausbildung der OLED das Aufbringen mindestens einer Schicht unter Verwendung einer organischen Dampfphasenabscheidung (OVPD) umfasst.

**10.** Lichtemittierende Vorrichtung, welche umfasst:

ein Substrat mit Oberflächenmerkmalen auf seiner Unterseite und seiner Oberseite, worin die Oberflächenmerkmale der Unterseite sphärische oder asphärische Linsen sind und die Oberflächenmerkmale der Oberseite Vertiefungsmerkmale sind, die komplementär zur Krümmung der Merkmale auf der Unterseite des Substrats sind; und
eine OLED, die über der oberen Oberfläche des Substrats ausgebildet ist, worin die OLED ein Profil aufweist, das der Form des Substrats entspricht, worin das Substrat aus einem volumenreduzierenden Polymer besteht und die Dicke des Substrats größer ist als die Spitze-zu-Mulde-Höhe des Substratoberflächenmerkmals und einen Bereich von 5 $\mu$m bis zu einigen hundert $\mu$m aufweist.

**11.** Vorrichtung nach Anspruch 10, wobei das volumenreduzierende Material ein lösliches Polymer ist.

**12.** Vorrichtung nach einem der Ansprüche 10 bis 11, welche ferner eine Planarisierungsschicht umfasst, die auf die obere Oberfläche des Substrats aufgebracht ist, worin die Planarisierungsschicht einen Brechungsindex aufweist, der größer oder gleich dem Brechungsindex des Substrats ist.

**13.** Vorrichtung nach einem der Ansprüche 10 bis 12, welche ferner ein reflektierendes Material umfasst, das über konkaven Merkmalen auf der oberen Oberfläche des Substrats aufgebracht ist, die nicht von der OLED bedeckt sind.

**14.** Vorrichtung nach einem der Ansprüche 10 bis 13, welche ferner eine über der OLED aufgebrachte Sperrschicht umfasst.

**15.** Vorrichtung nach einem der Ansprüche 10 bis 14, worin die Vorrichtung flexibel ist.


**Revendications**

**1.** Procédé de fabrication d'un dispositif électroluminescent, comprenant :

le dépôt d'un matériau à réduction de volume sur une surface d'un moule comportant des éléments de surface sur celle-ci ;
le durcissement du matériau à réduction de volume pour former un substrat conforme sur la surface du moule, le substrat conforme ayant un profil défini par les éléments de surface du moule, dans lequel les éléments de surface de substrat inférieurs du substrat conforme sont le résultat d'un contact direct avec la surface du moule et sont des lentilles sphériques ou asphériques, et les éléments de surface de substrat supérieurs du substrat conforme sont des éléments de cupule complémentaires de la courbure des éléments sur la surface inférieure du substrat ; et
la formation d'un OLED sur le substrat conforme tandis que le substrat est disposé sur la surface du moule.

**2.** Procédé selon la revendication 1, comprenant en outre le retrait du substrat conforme de la surface du moule, dans lequel le dispositif est flexible après le retrait du substrat conforme de la surface du moule.

**3.** Procédé selon la revendication 1 ou 2, dans lequel le matériau à réduction de volume comprend :

un polymère dissous dans un solvant, dans lequel l'étape de durcissement du matériau à réduction de volume comprend l'évaporation du solvant à partir du matériau à réduction de volume, et
dans lequel la surface supérieure du substrat conforme est conforme à la surface inférieure du substrat après durcissement, en réponse à un volume appliqué de matériau à réduction de volume et un rapport du polymère au solvant du matériau à réduction de volume appliqué.

**4.** Procédé selon l'une quelconque des revendications précédentes, dans lequel l'OLED a un profil conforme à la forme du substrat.

**5.** Procédé selon l'une quelconque des revendications précédentes, dans lequel les éléments de surface comprennent une pluralité de micropuits.

**6.** Procédé selon l'une quelconque des revendications précédentes, comprenant en outre l'application d'une couche de planarisation sur la surface supérieure du substrat conforme, dans lequel la couche de planarisation a un indice de réfraction supérieur ou égal à un indice de réfraction du substrat conforme.

**7.** Procédé selon l'une quelconque des revendications précédentes, comprenant en outre l'application d'un matériau réfléchissant sur des éléments concaves sur la surface supérieure du substrat conforme qui ne sont pas recouverts par l'OLED.

**8.** Procédé selon l'une quelconque des revendications précédentes, comprenant en outre l'application d'une couche barrière sur l'OLED.

**9.** Procédé selon l'une quelconque des revendications précédentes, dans lequel l'étape de formation de l'OLED comprend le dépôt d'au moins une couche au moyen d'un dépôt en phase vapeur organique (OVPD).

**10.** Dispositif électroluminescent, comprenant :

un substrat comportant des éléments de surface sur sa surface inférieure et sa surface supérieure, dans lequel les éléments de surface de substrat inférieurs sont des lentilles sphériques ou asphériques, et les éléments de surface de substrat supérieurs sont des éléments de cupule complémentaires de la courbure des éléments sur la surface inférieure du substrat ; et
un OLED, formé sur la surface supérieure du substrat, dans lequel l'OLED a un profil conforme à la forme du substrat, dans lequel le substrat est constitué d'un polymère à réduction de volume, et l'épaisseur du substrat est supérieure à une hauteur pic-vallée d'élément de surface de substrat, et a une plage de 5 $\mu$m à quelques centaines de $\mu$m.

**11.** Dispositif selon la revendication 10, dans lequel le matériau à réduction de volume est un polymère soluble.

**12.** Dispositif selon l'une quelconque des revendications 10 à 11, comprenant en outre une couche de planarisation appliquée sur la surface supérieure du substrat, dans lequel la couche de planarisation a un indice de réfraction supérieur ou égal à un indice de réfraction du substrat.

**13.** Dispositif selon l'une quelconque des revendications 10 à 12, comprenant en outre un matériau réfléchissant appliqué sur des éléments concaves sur la surface supérieure du substrat qui ne sont pas recouverts par l'OLED.

**14.** Dispositif selon l'une quelconque des revendications 10 à 13, comprenant en outre une couche barrière appliquée sur l'OLED.

**15.** Dispositif selon l'une quelconque des revendications 10 à 14, dans lequel le dispositif est flexible.

FIGURE 1

200

230

225

220

215

210

FIGURE 2

Providing a mold — 300

Forming a substrate — 310

Fabricating an OLED — 320

Removing the mold from the substrate and OLED — 330

FIGURE 3

321

```
                    ┌──────────────────┐  322
                    │  Applying an anode│
                    └──────────────────┘
                            │
                            ▼
                    ┌──────────────────┐  323
                    │ Applying organic │
                    │     material     │
                    └──────────────────┘
                            │
                            ▼
                    ┌──────────────────┐  324
                    │Applying a cathode│
                    └──────────────────┘
                            │
                            ▼
                    ┌──────────────────┐  325
                    │Applying a barrier│
                    │      layer       │
                    └──────────────────┘
                            │
                            ▼
                    ┌──────────────────┐  326
                    │ Applying a hard  │
                    │      coat        │
                    └──────────────────┘
```

FIGURE 4

Providing a mold — 500

Forming a substrate — 510

Applying electrodes and organic matter — 520

Applying a barrier layer — 530

Applying a first hard coat — 540

Removing the mold from the substrate and OLED — 550

Applying a second hard coat — 560

**FIGURE 5**

FIGURE 6A)

602

600

FIGURE 6B)

610

FIGURE 6C)

626
624  620
622

FIGURE 6D)

630

FIGURE 6E)

640
642

FIGURE 6F)

650

FIGURE 6G)

662
660

FIGURE 7A

702 702 702 702

705

700

712 712 712 712

FIGURE 7B

714 714 714 714

710

700

FIGURE 8

810

800

FIGURE 9

910

900

1002

1010

1004

FIGURE 10

FIGURE 11A

600'

604

626

FIGURE 11B

640

642

630

624

622

610

FIGURE 11C

650

FIGURE 12A

FIGURE 12B

FIGURE 12C

(A)

(B)

FIGURE 13

FIGURE 14

FIGURE 15

FIGURE 16A

FIGURE 16B

EP 3 067 952 B1

FIGURE 17A

FIGURE 17B

33

600, 700

1080

FIGURE 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 04219413
- US 10627413
- US 5844363 A
- US 6303238 B
- US 5707745 A
- WO 2008139370 A
- US 2012305950 A
- GB 2482193 A
- EP 2966669 A
- US 4769292 A
- US 7279704 B
- US 20030230980
- US 5703436 A
- US 6097147 A
- US 20040174116
- US 5247190 A, Friend
- US 6091195 A, Forrest
- US 5834893 A, Bulovic
- US 6013982 A
- US 6087196 A
- US 6337102 B, Forrest
- US 7431968 B
- US 6294398 B
- US 6468819 B
- US 7968146 B
- US 2007023098 W
- US 2009042829 W

**Non-patent literature cited in the description**

- **BALDO et al.** Highly Efficient Phosphorescent Emission from Organic Electroluminescent Devices. *Nature,* 1998, vol. 395, 151-154
- **BALDO et al.** Very high-efficiency green organic light-emitting devices based on electro phosphorescence. *Appl. Phys. Lett.,* 1999, vol. 75 (3), 4-6
- **J. A. ROGERS ; G. R. BOGART.** *J. Mater. Res.,* 2001, vol. 16 (1), 217